# EUROPÄISCHE PATENTSCHRIFT

(11) **EP 3 396 455 B1**
(45) Veröffentlichungstag und Bekanntmachung des Hinweises auf die Patenterteilung: **05.10.2022**
(21) Anmeldenummer: 17168663.7
(22) Anmeldetag: 28.04.2017
(51) Int. Cl.: G03F 7/00, G03F 7/038, G03F 7/032

(54) **LICHTHÄRTBARE ZUSAMMENSETZUNG**
PHOTOCURABLE COMPOSITION
COMPOSITION PHOTODURCISSABLE

(43) Veröffentlichungstag der Anmeldung: 31.10.2018
(73) Patentinhaber: Technische Universität Wien, 1040 Wien (AT)
(72) Erfinder: Steyrer, Bernhard, 3430 Tulln (AT); Stampfl, Jürgen, 1050 Wien (AT); Liska, Robert, 2123 Schleinbach (AT)
(74) Vertreter: Ellmeyer, Wolfgang

(56) Entgegenhaltungen:
- EP-A1- 1 371 695
- WO-A1-03/099947
- WO-A1-2008/125202
- WO-A2-2014/126830
- DE-A1- 10 150 256
- JP-A- 2006 285 178

## Beschreibung

Die Erfindung betrifft eine lichthärtbare Zusammensetzung zur Verwendung als photopolymerisierbares Material in einem generativen Fertigungsprozess.

### STAND DER TECHNIK

Lithographiebasierte generative Fertigung, wie z.B. Stereolithographie, wird -wie auch 3D-Druckverfahren allgemein - traditionell hauptsächlich für die Herstellung von Prototypen und Funktionsmustern verwendet ("Rapid Prototyping"). Durch technische Weiterentwicklungen rücken zusehends echte Produktionsanwendungen in den Fokus, wie z.B. transparente Zahnspangen oder Hörgeräteschalen. Für die Anwendung sind die mechanischen und thermischen Eigenschaften der Druckmaterialien von entscheidender Bedeutung. Derzeit für die generative Fertigung verfügbare Materialien besitzen jedoch noch nicht die mechanischen Eigenschaften von konventionellen Fertigungsmaterialien (siehe z.B. T. Swetly, J. Stampfl, G. Kempf und R.-M. Hucke, "Capabilities of additive manufacturing technologies (AMT) in the validation of the automotive cockpit", RTejournal - Forum für Rapid Technologie 2014(1)).

Diese Materialien (Harze) für die generative Fertigung basieren auf reaktiven Komponenten, die belichtet und dadurch ausgehärtet werden können. Hierfür werden häufig die radikalische (z.B. für Acrylate) bzw. die kationische (z.B. für Epoxide) Polymerisation eingesetzt. Dazu werden spezielle Photoinitiatoren dem Harz zugegeben, die durch Belichtung ihren Zustand ändern und dadurch die Polymerisation der reaktiven Komponenten auslösen.

Für die generative Fertigung von Objekten aus diesen Harzen stehen verschiedene Verfahren wie z.B. Stereolithographie, Digital Light Processing und Multi-Jet Modelling zur Verfügung. Bei allen Verfahren werden diese Harze Schicht für Schicht ausgehärtet und so ein dreidimensionales Objekt hergestellt. In der Regel sind hierfür Harze mit niedriger Viskosität erforderlich, z.B. 20-40 mPa.s (siehe I. Gibson, D. W. Rosen, B. Stucker et al., "Additive manufacturing technologies", Bd. 238, Springer Verlag (2010)).

Um die mechanischen Eigenschaften, speziell die Zähigkeit bzw. die Bruchdehnung, von auf diese Weise gehärteten Produkten zu verbessern, muss allerdings die Vernetzungsdichte reduziert bzw. das Molekulargewicht der Monomere erhöht werden. Dies erhöht jedoch die Viskosität bzw. den Schmelzpunkt der ungehärteten Harze, weswegen Letztere bis vor kurzem nicht mittels generativer Fertigungsverfahren gehärtet werden konnten.

Neue Entwicklungen machen es jedoch möglich, auch Harze mit höherer Viskosität zu verarbeiten. So werden etwa in WO 2015/075094 A1 und WO 2016/078838 A1 Stereolithographievorrichtungen offenbart, bei denen die sequentiell auszuhärtenden Schichten aus polymerisierbarem Material beheizbar sind, was es erlaubt, selbst hochviskose Harze zu verarbeiten. In WO 2015/074088 A2 werden photopolymerisierbare Zusammensetzungen mit einer Viskosität bei Raumtemperatur von zumindest 20 Pa.s offenbart, die während der Härtung auf zumindest 30 °C erwärmt werden. Zum Vergleich: 20 Pa.s. entsprechen etwa der Viskosität von Ethylenglykol oder zähflüssigem Honig, während Butter mit einer Viskosität von etwa 30 Pa.s kaum noch fließfähig ist.

Als weitere den Stand der Technik beschreibende Dokumente werden WO 2008/125202 A1, EP 1 371 695 A1, DE 101 50 256 A1, JP 2006 285178 A, WO 2014/126830 A2 und WO 03/099947 A1 genannt.

Weiterhin ungelöst sind jedoch Probleme hinsichtlich der mechanischen Eigenschaften der gehärteten Produkte, wie z.B. von 3D-Druckteilen. Beispielsweise weisen solche Produkte unzureichende Schlagzähigkeit und Dehnbarkeit auf, sind zu spröde und nehmen zu große Anteile an Wasser aus der Umgebungsluft auf.

Ziel der vorliegenden Erfindung war daher die Bereitstellung verbesserter lichthärtbarer Zusammensetzungen für generative Fertigungsverfahren.

### OFFENBARUNG DER ERFINDUNG

Dieses Ziel erreicht die Erfindung durch Bereitstellung der Verwendung einer lichthärtbaren Zusammensetzung als photopolymerisierbares Material in einem generativen Fertigungsprozess unter Erwärmung der Zusammensetzung, die bei 20 °C eine Viskosität von zumindest 20 Pa.s aufweist und folgende Komponenten umfasst:
- ein photopolymerisierbares Matrixmaterial,
- zumindest ein darin gelöstes thermoplastisches Polymer und
- zumindest einen Photoinitiator;
mit dem Kennzeichen, dass als gelöstes thermoplastisches Polymer Polycaprolacton oder ein Derivat davon eingesetzt wird.

Überraschenderweise hat sich herausgestellt, dass Polycaprolacton anderen hochmolekularen Thermoplasten hinsichtlich der mechanischen Eigenschaften der im generativen Fertigungsprozess gehärteten Produkte weit überlegen ist, wie die nachfolgenden Ausführungsbeispiele klar belegen.

In bevorzugten Ausführungsformen der Erfindung weist das Polycaprolacton oder dessen Derivat ein Molekulargewicht von zumindest 50.000 g/mol, noch bevorzugter zumindest 70.000 g/mol, auf und/oder ist in einem Anteil von 2 bis 30 Gew.-%, noch bevorzugter 5 bis 15 Gew.-%, insbesondere etwa 10 Gew.-%, in dem photopolymerisierbaren Matrixmaterial gelöst, was die mechanischen Eigenschaften weiter verbessert. Außerdem wird vorzugsweise unmodifiziertes Polycaprolacton als gelöstes thermoplastisches Polymer eingesetzt, wenngleich in manchen Fällen beispielsweise ein bestimmter Anteil des Polycaprolactons mit polymerisierbaren Gruppen, Farbstoffgruppierungen, Photo- oder thermischen Initatorgruppierungen oder dergleichen modifiziert sein kann. Darüber hinaus können gemäß vorliegender Erfindung auch Copolymere von Caprolacton, z.B. mit Lactid, mit entsprechenden Eigenschaften eingesetzt werden. Für den Fachmann versteht es sich, dass solange die Derivatisierung ein bestimmtes Maß nicht übersteigt, für die allermeisten Polycaprolacton-Derivate ähnliche oder im Wesentlichen dieselben Vorteile zu erwarten sind wie für Polycaprolacton selbst.

Weiters wird gemäß vorliegender Erfindung bevorzugt, dass das photopolymerisierbare Matrixmaterial zumindest einen, vorzugsweise monofunktionellen, Reaktivverdünner und zumindest einen di- oder höherfunktionellen Vernetzer umfasst, um einerseits ausreichend gutes Lösevermögen für das hochmolekulare Polycaprolacton(-Derivat) zu bieten und andererseits gute mechanische Eigenschaften des gehärteten Produkts zu gewährleisten.

Der zumindest eine Reaktiwerdünner macht dabei vorzugsweise einen Anteil von 30 bis 80 Gew.-% und der zumindest eine Vernetzer 70 bis 20 Gew.-% des photopolymerisierbaren Matrixmaterials aus, wobei besonders bevorzugt entweder gleich hohe Massenanteile an Reaktivverdünner und Vernetzer oder höhere Anteils an Reaktivverdünner vorliegen. Dies hängt unter anderem von der Vernetzungsdichte und somit auch von den Funktionalitäten der beiden Matrixkomponenten ab. Der zumindest eine Reaktivverdünner weist zudem vorzugsweise bei 20 °C eine Viskosität von nicht mehr als 0,1 Pa.s auf, um in Kombination mit dem Vernetzer und dem gelösten Polycaprolacton(-Derivat) für eine geeignete Viskosität zu sorgen.

Sowohl als Reaktivverdünner als auch als Vernetzer sind (Meth)acrylate zu bevorzugen, da diese in breiten Bereichen von Molekulargewicht und Funktionalitäten verfügbar und gut erforscht sind und darüber hinaus gute Löslichkeit für das Polycaprolacton bieten und der lichthärtenden Zusammensetzung thermische Stabilität verleihen. Die Matrix muss nämlich so zusammengesetzt sein, dass die Siedepunkte und die Zersetzungstemperaturen der einzelnen Komponenten deutlich über der Verarbeitungstemperatur im generativen Fertigungsprozess liegen. Beispiele für monofunktionelle Reaktivverdünner sind isobornyl(meth)acrylat, Dicyclopentadienyl(meth)acrylat und (Meth)-acryloylmorpholin.

Als Vernetzer wird in bevorzugten Ausführungsformen ein Oligomer, vorzugsweise mit endständigen polymerisierbaren Gruppierungen und mit einem Molekulargewicht von zumindest 400 g/mol, das auch mehrere tausend, bis hin zu 5.000, 10.000 oder gar 20.000 g/mol betragen kann, eingesetzt, um keine übermäßig hohe Vernetzungsdichte zu erzeugen. Beispiele für difunktionelle (Meth)acrylat-Vernetzer sind Polyethylenglykoldimethacrylat, ethoxyliertes Bisphenol-A-di(meth)acrylat, aliphatische Polyesterurethanacrylate (z.B. Bomar BR-741) oder -methacrylate (z.B. Bomar XR-741 MS).

In weiteren bevorzugten Ausführungsformen weist die Zusammensetzung bei 20 °C eine Viskosität von zumindest 50 Pa.s, noch bevorzugter von zumindest 80 Pa.s, insbesondere von zumindest 100 Pa.s, auf, liegt also bei Raumtemperatur nicht nur in einem hochviskos-flüssigen, sondern sogar in festem Zustand vor, was die Lagerbarkeit vor ihrer Verwendung im generativen Fertigungsprozess begünstigt.

Darüber hinaus kann die lichthärtbare Zusammensetzung auch zumindest eine weitere Komponente, ausgewählt aus thermischen Initiatoren, Farbstoffen, Füllern und Modifikatoren umfassen, wie sie auf dem Gebiet von generativer Fertigung und 3D-Druck üblich sind.

### BEISPIELE

Nachstehend wird die vorliegende Erfindung anhand von konkreten Ausführungs- und Vergleichsbeispielen sowie unter Bezugnahme auf die beiliegenden Zeichnungen näher beschrieben, die Folgendes zeigen.
Fig. 1 zeigt die Ergebnisse eines Schlagzähigkeitstests verschiedener, in erfindungsgemäßen und in Vergleichsbeispielen hergestellter Photopolymere; und
Fig. 2 zeigt den Viskositätsverlauf einer Zusammensetzung zur Verwendung gemäß Beispiel 5 der vorliegenden Erfindung.

### Beispiele 1 bis 4, Vergleichsbeispiele 1 bis 6

Zusammensetzungen zur erfindungsgemäßen Verwendung wurden in den in der umseitigen Tabelle 1 angegebenen Mengenverhältnissen hergestellt und enthielten zusätzlich jeweils 0,5 phr ("parts per hundred rubber", d.h. Teile pro 100 Massenteile des Matrixmaterials) an Ivocerin, eines von Ivoclar Vivadent erhältlichen Photoinitiators.

Die Zusammensetzungen aller Vergleichsbeispiele sowie jene von Beispiel 1, die die Matrizes 1 bis 3 umfassten, enthielten jeweils 15 Gew.-% des jeweiligen löslichen Thermoplasten bzw. Polycaprolacton, jene der erfindungsgemäßen Beispiele 2 bis 4 mit Matrix 4 enthielt hingegen nur jeweils 10 Gew.-% Polycaprolacton, in allen Fällen bezogen auf 100 Gew.-% der Matrix und des Thermoplasten zusammen.

**Tabelle 1**

| **Beispiel** | **Reaktivverdünner** | **Vernetzer** | **Thermoplast** |
|---|---|---|---|
| Matrix 1, M1 | 66,7% IBMA ¹⁾ | 33,3% SR834 ²⁾ | - |
| Vergleichsbeispiel 1, V1 | -" - | -" - | 15% RB810 ³⁾ |
| Vergleichsbeispiel 2, V2 | - " - | - " - | 15% RB830 ⁴⁾ |
| Vergleichsbeispiel 3, V3 | - " - | - " - | 15% SBR BL ⁵⁾ |
| Vergleichsbeispiel 4, V4 | " | " | 15% SBR SL ⁶⁾ |
| Vergleichsbeispiel 5, V5 | - " - | - " - | 15% SBR SE ⁷⁾ |
| Matrix 2, M2 | 90% HEMA ⁸⁾ | 10% SR348L ⁹⁾ | - |
| Vergleichsbeispiel 6, V6 | - " - | - " - | 15% TPU ¹⁰⁾ |
| Matrix 3, M3 | 70% IBMA | 30% EO(30)BPA-DMA ¹¹⁾ | - |
| **Beispiel 1, B1** | " | " | 15% PCL 80 ¹²⁾ |
| Matrix 4, M4 | 50% IBMA | 30% EO(30)BPA-DMA 20% XR741 ¹³⁾ | - |
| **Beispiel 2, B2** | - " - | - " - | 10% PCL 25 ¹⁴⁾ |
| **Beispiel 3, B3** | - " - | - " - | 10% PCL 50 ¹⁵⁾ |
| **Beispiel 4, B4** | - " - | - " - | 10% PCL 80 |

| | | | |
|---|---|---|---|
| 1) IBMA: Isobornylmethacrylat von Sigma Aldrich 2) SR834: Tricyclodecandimethanol-dimethacrylat von Sartomer 3) RB810: syndiotaktisches 1,2-Polybutadien von JSR, 90% 1,2-Bindungen, Mn 120.000 g/mol 4) RB830: syndiotaktisches 1,2-Polybutadien von JSR, 93% 1,2-Bindungen, Mn 120.000 g/mol 5) SBR BL: Styrol-Butadien-Copolymer von Lanxess, Buna BL 30-4548, 48% Styrol, 30% in Blockform 6) SBR SL: Styrol-Butadien-Copolymer von Lanxess, Buna SL 4525-0, 25% Styrol, aus Lösungspolym. 7) SBR SE: Styrol-Butadien-Copolymer von Lanxess, Buna SE 1502, 23,5% Styrol, aus Emulsionspol. 8) HEMA: Hydroxyethylmethacrylat von Sigma Aldrich 9) SR348L: ethoxyliertes (2) Bisphenol-A-dimethacrylat von Sartomer 10) TPU: thermoplastisches Polyurethan von Covestro, Desmopan DP 85085A, Mn 160.000 g/mol 11) EO(30)BPA-DMA: ethoxyliertes (30) Bisphenol-A-dimethacrylat von Sigma Aldrich, Mn 1.700 g/mol 12) PCL 80: Polycaprolacton von Perstorp, Capa 6800, Mn 80.000 g/mol 13) XR741: difunktionelles aliphatisches Polyesterurethanmethacrylat von Dymax, Bomar XR-741 MS 14) PCL 25: Polycaprolacton von Perstorp, Capa 6250, Mn 25.000 g/mol 15) PCL 50: Polycaprolacton von Perstorp, Capa 6506, Mn 50.000 g/mol | | | |

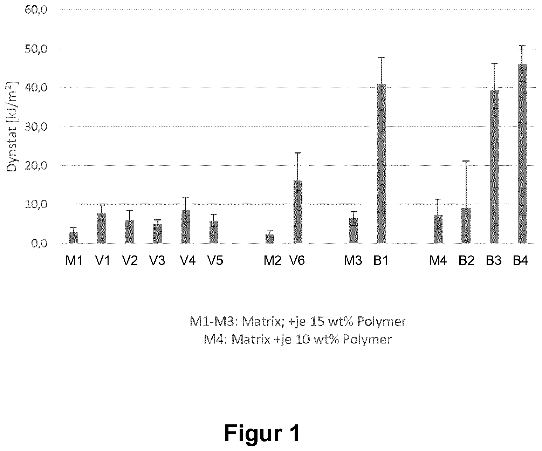

Zur Simulation eines generativen Fertigungsprozesses wurden die Zusammensetzungen bei 80 °C in Formen gegossen und sofort mit einer Uvitron Intelliray 600 UV-Kammer bei 100 % Leistung 500 s lang belichtet und dadurch gehärtet. Die Proben wurden aus der Form entnommen, um 180° gewendet und ein weiteres Mal 500 s lang gehärtet. Die Probekörper wurden anschließend mit Schleifpapier der Körnung 1000 auf 4 mm Dicke geschliffen und gemäß ISO 291 zumindest 88 h lang bei 23 °C und 50 % Luftfeuchtigkeit konditioniert. Die Probekörper der Matrix M2 sowie von Vergleichsbeispiel 6 wurden für 14 Tage konditioniert. Danach erfolgte eine Prüfung der Schlagzähigkeit gemäß DIN 53435, und die Ergebnisse sind in Fig. 1 dargestellt.

Aus der Zeichnung geht klar hervor, dass mit den meisten löslichen Thermoplasten der Vergleichsbeispiele keine nennenswerte Verbesserung der Schlagzähigkeit erzielt werden konnte. Nur das thermoplastische Polyurethan in Vergleichsbeispiel 6 steigerte die Schlagzähigkeit des Matrixmaterials 3 deutlich. Allerdings handelte es sich dabei um einen Thermoplasten mit einem mittleren Molekulargewicht von 160.000 g/mol in einem Anteil von 15 Gew.-%.

Zum Vergleich erhöhte das Polycaprolacton in Beispiel 1 in einem Anteil von ebenfalls 15 Gew.-% die Schlagzähigkeit des Matrixmaterials 3 in ähnlich starkem Ausmaß, obwohl es nur ein mittleres Molekulargewicht von 80.000 g/mol aufwies.

In den Zusammensetzungen der Beispiele 2 bis 4 war das Polycaprolacton nur in einem Anteil von 10 Gew.-% enthalten, weswegen das Polycaprolacton "PCL 25" in Beispiel 2 mit einem mittleren Molekulargewicht von 25.000 g/mol nur eine geringe Verbesserung der Schlagzähigkeit des Matrixmaterials 4 bewirkte. Dafür verbesserten die Caprolactone der Beispiele 3 und 4 mit Molekulargewichten von 50.000 bzw. 80.000 g/mol die Schlagzähigkeit der Matrix ohne Thermoplast allerdings wiederum erheblich.

### Vergleich der Wasseraufnahme

Da die sonstigen löslichen Thermoplaste der Vergleichsbeispiele sich bereits als wenig erfolgsversprechend erwiesen hatten, wurden in einem weiteren Test nur der Probekörper von Vergleichsbeispiel 6 (V6) mit thermoplastischem Polyurethan und jener von Beispiel 4 (B4) mit Polycaprolacton mit 80.000 g/mol in Bezug auf ihre Wasseraufnahme getestet. Dazu wurden beide Probekörper 8 Tage lang unter 100 % Luftfeuchtigkeit aufbewahrt, wonach für V6 eine Gewichtszunahme von 17,0 % konstatiert wurde, während für B4 nahezu keine festzustellen war. Selbst nach dem Einlegen von B4 in Wasser für 28 Tage war lediglich ein Gewichtszuwachs von 2,9 % zu beobachten, was belegt, dass die Polycaprolacton enthaltende Zusammensetzung aus Beispiel 4 jener aus Vergleichsbeispiel 6 mit Polyurethan als Thermoplast und deutlich polareren Matrixkomponenten, wie sie zum Lösen des Polyurethans unumgänglich sind, in Bezug auf die Wasseraufnahme deutlich überlegen war.

### Beispiel 5

Das Polycaprolacton "PCL 80" mit einem mittleren Molekulargewicht von 80.000 g/mol, das bislang am besten abgeschnitten hatte, wurde ein praxisidenter 3D-Druckversuch unternommen. Dazu wurde die folgende Zusammensetzung hergestellt, wobei sowohl die Reaktivverdünner- als auch die Vernetzer-Komponente der Matrix mit MEHQ als Polymerisationsinhibitor angeliefert wurden.

**Tabelle 2**

| **Beispiel** | **Reaktivverdünner** | **Vernetzer** | **Thermoplast** | **Zusätze** |
|---|---|---|---|---|
| Matrix 5 | 45% IBMA ¹⁾ 150 ppm MEHQ ²⁾ | 27% EO(30)BPA-DMA ³⁾ 18% XR741 ⁴⁾ 200 ppm MEHQ | - | |
| **Beispiel 5** | - " - | - " - | 10% PCL 80 ⁵⁾ | 0,15 phr Ivocerin 0,5 phr ABCN ⁶⁾ 0,075 phr SY ⁷⁾ |

| | | | | |
|---|---|---|---|---|
| 1) IBMA: Isobornylmethacrylat von Sigma Aldrich 2) MEHQ: Hydrochinonmethylether (4-Methoxyphenol), Polymerisationsinhibitor von Sigma Aldrich 3) EO(30)BPA-DMA: ethoxyliertes (30) Bisphenol-A-dimethacrylat von Sigma Aldrich, Mn 1.700 g/mol 4) XR741: difunktionelles aliphatisches Polyesterurethanmethacrylat von Dymax, Bomar XR-741MS 5) PCL 80: Polycaprolacton von Perstorp, Capa 6800, Mn 80.000 g/mol 6) ABCN: 1,1'-Azobis(cyclohexancarbonitril), ein thermischer Initiator von Sigma Aldrich 7) SY: Sudan Yellow 177, ein Farbstoff von John Hogg | | | | |

Hierzu wurden 45 g der beiden Vernetzer und 45 g des Reaktivverdünners in einem beheizbaren Gefäß mit mechanischer Rühreinheit 30 min lang bei 60 °C gerührt. Danach wurden 10 g Polycaprolacton zugegeben, und das Gemisch wurde auf 80 °C erhitzt, 6 h lang bei dieser Temperatur gerührt und anschließend auf Raumtemperatur abgekühlt. Das nun feste Gemisch wurde entnommen und in einen Kunststoffbecher übergeführt, wo es erneut auf 80 °C erhitzt wurde und der Photoinitiator (Ivocerin), der thermische Initiator (ABCN) und der Farbstoff (SY) zugegeben wurden. Das Gemisch wurde 10 min lang in einer dualen asymmetrischen Zentrifuge bei 3500 U/min homogenisiert.

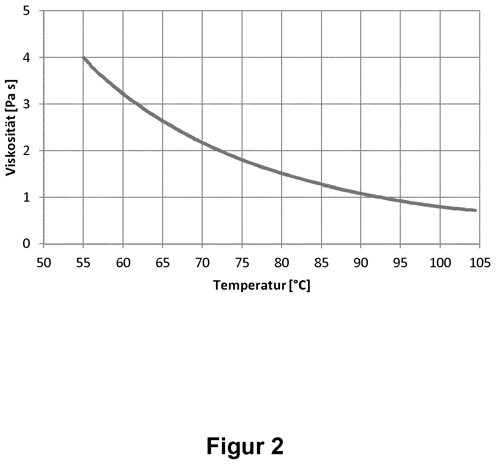

Die so erhaltene Zusammensetzung war bei Raumtemperatur fest und wies einen mittels DSC (Heizrate: 10 K/min) bestimmten (unkorrigierten) Schmelzpunkt von etwa 42,5 °C auf. Weiters wurde die Viskosität mit einem Kegel-Platte-Viskosimeter, 25 mm Durchmesser, 49 µm Prüfspalt, bei einer Scherrate von 50 s⁻¹ und einer Heizrate von 0,05 °C/s bestimmt. Der temperaturabhängige Viskositätsverlauf der Zusammensetzung ist in Fig. 2 dargestellt.

Das Material wurde anschließend auf einem beheizten DLP- ("digital light processing") 3D-Drucker bei 60 °C verarbeitet. Die so gedruckten Prüfkörper wiesen bei einer Zugprüfung gemäß ISO 527 mit Prüfkörpern vom Typ 5B ausgezeichnete Zugeigenschaften, nämlich eine Bruchdehnung von rund 100 %, und bei Prüfung mit einem Texas Instruments Dynamic Mechanical Analyzer DMA 2980 von -50 bis 150 °C mit 1 Hz und einer Amplitude von 20 µm ausgezeichnete thermomechanische Eigenschaften hinsichtlich Speichermodul und Dämpfung (tangens Delta) auf.

Die obigen Beispiele für die vorliegende Erfindung belegen somit klar die Vorteile der erfindungsgemäßen Verwendung von Polycaprolacton als löslicher Thermoplast in lichthärtenden Zusammensetzungen für generative Fertigungsprozesse und 3D-Druck.

## Patentansprüche

1. Verwendung einer lichthärtbaren Zusammensetzung als photopolymerisierbares Material in einem generativen Fertigungsprozess unter Erwärmung der Zusammensetzung, die bei 20 °C eine Viskosität von zumindest 20 Pa.s aufweist und folgende Komponenten umfasst:
- ein photopolymerisierbares Matrixmaterial,
- zumindest ein darin gelöstes thermoplastisches Polymer und
- zumindest einen Photoinitiator;
**dadurch gekennzeichnet, dass** als gelöstes thermoplastisches Polymer Polycaprolacton oder ein Derivat davon eingesetzt wird.

2. Verwendung nach Anspruch 1, **dadurch gekennzeichnet, dass** das Polycaprolacton oder dessen Derivat ein zahlenmittleres Molekulargewicht Mn von zumindest 50.000 g/mol aufweist.

3. Verwendung nach Anspruch 2, **dadurch gekennzeichnet, dass** das Polycaprolacton oder dessen Derivat ein zahlenmittleres Molekulargewicht Mn von zumindest 70.000 g/mol aufweist.

4. Verwendung nach einem der Ansprüche 1 bis 3, **dadurch gekennzeichnet, dass** das Polycaprolacton oder dessen Derivat in einem Anteil von 2 bis 30 Gew.-%, bezogen auf 100 Gew.-% der Matrix und des thermoplastischen Polymers zusammen, in dem photopolymerisierbaren Matrixmaterial gelöst ist.

5. Verwendung nach Anspruch 4, **dadurch gekennzeichnet, dass** das Polycaprolacton oder dessen Derivat in einem Anteil von 5 bis 15 Gew.-%, bezogen auf 100 Gew.-% der Matrix und des thermoplastischen Polymers zusammen, in dem photopolymerisierbaren Matrixmaterial gelöst ist.

6. Verwendung nach Anspruch 5, **dadurch gekennzeichnet, dass** das Polycaprolacton oder dessen Derivat in einem Anteil von etwa 10 Gew.-%, bezogen auf 100 Gew.-% der Matrix und des thermoplastischen Polymers zusammen, in dem photopolymerisierbaren Matrixmaterial gelöst ist.

7. Verwendung nach einem der Ansprüche 1 bis 6, **dadurch gekennzeichnet, dass** als gelöstes thermoplastisches Polymer Polycaprolacton eingesetzt wird.

8. Verwendung nach einem der Ansprüche 1 bis 7, **dadurch gekennzeichnet, dass** das photopolymerisierbare Matrixmaterial zumindest einen monofunktionellen Reaktivverdünner und zumindest einen di- oder höherfunktionellen Vernetzer umfasst.

9. Verwendung nach Anspruch 8, **dadurch gekennzeichnet, dass** als Reaktiwerdünner und/oder als Vernetzer ein oder mehrere (Meth)acrylate eingesetzt werden.

10. Verwendung nach Anspruch 8 oder 9, **dadurch gekennzeichnet, dass** der zumindest eine Reaktivverdünner 30 bis 80 Gew.-% und der zumindest eine Vernetzer 70 bis 20 Gew.-% des photopolymerisierbaren Matrixmaterials ausmachen.

11. Verwendung nach einem der Ansprüche 8 bis 10, **dadurch gekennzeichnet, dass** der zumindest eine Reaktiwerdünner bei 20 °C eine Viskosität von nicht mehr als 0,1 Pa.s aufweist.

12. Verwendung nach einem der Ansprüche 8 bis 11, **dadurch gekennzeichnet, dass** als Vernetzer ein Oligomer mit einem Molekulargewicht von zumindest 400 g/mol, zumindest 1.000 g/mol, zumindest 5.000 g/mol oder zumindest 10.000 g/mol eingesetzt wird.

13. Verwendung nach einem der Ansprüche 1 bis 12, **dadurch gekennzeichnet, dass** die Zusammensetzung bei 20 °C eine Viskosität von zumindest 50 Pa.s aufweist.

14. Verwendung nach Anspruch 13, **dadurch gekennzeichnet, dass** die Zusammensetzung bei 20 °C eine Viskosität von zumindest 80 Pa.s aufweist.

15. Verwendung nach einem der Ansprüche 1 bis 14, **dadurch gekennzeichnet, dass** die lichthärtbare Zusammensetzung zumindest eine weitere Komponente, ausgewählt aus thermischen Initiatoren, Farbstoffen, Füllern und Modifikatoren umfasst.

## Claims

1. A use of a photocurable composition as a photopolymerizable material in an additive manufacturing process that comprises heating the composition, which has a viscosity of at least 20 Pa.s at 20 °C and comprises the following components:
- a photopolymerizable matrix material,
- at least one thermoplastic polymer dissolved therein, and
- at least one photoinitiator;
**characterized in that** polycaprolactone or a derivative thereof is used as said dissolved thermoplastic polymer.

2. The use according to Claim 1, **characterized in that** the polycaprolactone or its derivative has a number-average molecular weight Mn of at least 50,000 g/mol.

3. The use according to Claim 2, **characterized in that** the polycaprolactone or its derivative has a number-average molecular weight Mn of at least 70,000 g/mol

4. The use according to any of Claims 1 to 3, **characterized in that** the polycaprolactone or its derivative is dissolved in the photopolymerizable matrix material in a proportion of 2 to 30 % by weight, based on 100 % by weight of the matrix and the thermoplastic polymer taken together.

5. The use according to Claim 4, **characterized in that** the polycaprolactone or its derivative is dissolved in the photopolymerizable matrix material in a proportion of 5 to 15 % by weight, based on 100 % by weight of the matrix and the thermoplastic polymer taken together.

6. The use according to Claim 5, **characterized in that** the polycaprolactone or its derivative is dissolved in the photopolymerizable matrix material in a proportion of about 10 % by weight, based on 100 % by weight of the matrix and the thermoplastic polymer taken together.

7. The use according to any of Claims 1 to 6, **characterized in that** polycaprolactone is used as said dissolved thermoplastic polymer.

8. The use according to any of Claims 1 to 7, **characterized in that** said photopolymerizable matrix material comprises at least one monofunctional reactive diluent and at least one di- or higher functional crosslinking agent.

9. The use according to Claim 8, **characterized in that** one or more (meth)acrylate(s) is/are used as said reactive diluent(s) and/or said crosslinking agent(s).

10. The use according to Claim 8 or 9, **characterized in that** said at least one reactive diluent accounts for 30 to 80 % by weight and said at least one crosslinking agent accounts for 70 to 20 % by weight of said photopolymerizable matrix material.

11. The use according to any one of Claims 8 to 10, **characterized in that** said at least one reactive diluent has a viscosity of not more than 0.1 Pa.s at 20 °C.

12. The use according to any one of Claims 8 to 11, **characterized in that** an oligomer having a molecular weight of at least 400 g/mol, at least 1,000 g/mol, at least 5,000 g/mol or at least 10,000 g/mol is used as said crosslinking agent.

13. The use according to any one of Claims 1 to 12, **characterized in that** the composition has a viscosity of at least 50 Pa.s at 20 °C.

14. The use according to Claim 13, **characterized in that** the composition has a viscosity of at least 80 Pa.s at 20 °C.

15. The use according to any one of Claims 1 to 14, **characterized in that** the photocurable composition comprises at least one further component selected from thermal initiators, dyes, fillers, and modifiers.

## Revendications

1. Utilisation d'une composition photodurcissable comme matière photopolymérisable dans un procédé de fabrication additif par chauffage de la composition ayant une viscosité à 20 °C d'au moins 20 Pa.s et comportant les composantes suivantes :
- une matière de matrice photopolymérisable,
- au moins un polymère thermoplastique y dissous et
- au moins un photoinitiateur ;
**caractérisée en ce que** de la polycaprolactone ou un dérivé de celle-ci est utilisé(e) comme polymère thermoplastique dissous.

2. Utilisation selon la revendication 1, **caractérisée en ce que** la polycaprolactone ou son dérivé a une moyenne numérique du poids moléculaire Mn d'au moins 50.000 g/mol.

3. Utilisation selon la revendication 2, **caractérisée en ce que** la polycaprolactone ou son dérivé a une moyenne numérique du poids moléculaire Mn d'au moins 70.000 g/mol.

4. Utilisation selon l'une quelconque des revendications 1 à 3, **caractérisée en ce que** la polycaprolactone ou son dérivé est dissoute/dissous dans la matière de matrice photopolymérisable dans une fraction de 2 à 30 % en poids, par rapport à 100 % en poids de la matrice et du polymère thermoplastique ensemble.

5. Utilisation selon la revendication 4, **caractérisée en ce que** la polycaprolactone ou son dérivé est dissoute/dissous dans la matière de matrice photopolymérisable dans une fraction de 5 à 15 % en poids, par rapport à 100 % en poids de la matrice et du polymère thermoplastique ensemble.

6. Utilisation selon la revendication 5, **caractérisée en ce que** la polycaprolactone ou son dérivé est dissoute/dissous dans la matière de matrice photopolymérisable dans une fraction d'environ 10 % en poids, par rapport à 100 % en poids de la matrice et du polymère thermoplastique ensemble.

7. Utilisation selon l'une quelconque des revendications 1 à 6, **caractérisée en ce que** de la polycaprolactone est utilisée comme polymère thermoplastique dissous.

8. Utilisation selon l'une quelconque des revendications 1 à 7, **caractérisée en ce que** la matière de matrice photopolymérisable comprend au moins un diluant réactif monofonctionnel et au moins un agent réticulant difonctionnel ou de fonctionnalité supérieure.

9. Utilisation selon la revendication 8, **caractérisé en ce qu'**un ou plusieurs (méth)-acrylates sont utilisés comme diluant réactif et/ou comme agent réticulant.

10. Utilisation selon l'une quelconque des revendications 8 ou 9, **caractérisée en ce que** l'au moins un diluant réactif représente 30 à 80 % en poids et l'au moins un agent réticulant représente 70 à 20 % en poids de la matière de matrice photopolymérisable.

11. Utilisation selon l'une quelconque des revendications 8 à 10, **caractérisée en ce que** l'au moins un diluant réactif a une viscosité à 20 °C n'excédant pas 0,1 Pa.s.

12. Utilisation selon l'une quelconque des revendications 8 à 11, **caractérisée en ce qu'**un oligomère ayant un poids moléculaire d'au moins 400 g/mol, au moins 1.000 g/mol, au moins 5.000 g/mol ou au moins 10.000 g/mol est utilisé comme agent réticulant.

13. Utilisation selon l'une quelconque des revendications 1 à 12, **caractérisée en ce que** la composition a une viscosité à 20 °C d'au moins 50 Pa.s.

14. Utilisation selon la revendication 13, **caractérisée en ce que** la composition a une viscosité à 20 °C d'au moins 80 Pa.s.

15. Utilisation selon l'une quelconque des revendications 1 à 14, **caractérisée en ce que** la composition photodurcissable comprend au moins une autre composante choisie parmi les initiateurs thermiques, les colorants, les agents de remplissage et les modificateurs.
